# EUROPEAN PATENT APPLICATION

(11) **EP 0 645 822 A1**
(43) Date of publication of application: **29.03.1995**
(21) Application number: 94111745.9
(22) Date of filing: 28.07.1994
(51) Int. Cl.: H01L 29/772

(54) **High efficiency electrically adjustable width field effect transistor and method therefor**

(30) Priority: 30.08.1993 US 112918
(71) Applicant: MOTOROLA, INC., Schaumburg, IL 60196 (US)
(72) Inventor: Weitzel, Charles E., Mesa, Arizona 85202 (US); Halchin, David J., Chandler, Arizona 85224 (US)
(74) Representative: Hudson, Peter David

(57) **Abstract**

A variable width FET (field effect transistor) (11) for reducing power consumption. The variable width FET (11) comprises a FET (18), a switch FET (19), and a switch FET (21). The switch FETs (21,19) have a gate, a drain and a source in parallel with a gate, a drain, and a source of the FET (18). Furthermore, the switch FETs (21,19) each have a control gate for enabling the corresponding the device. Enabling the switch FETs (21,19) increase the width of the variable width FET (11) thereby increasing its power handling capability. Disabling the switch FETs (18,19) reduces the width of the variable width FET (11) thereby reducing DC bias currents needed which reduces power consumption.

## Description

### Background of the Invention

This invention relates, in general, to power transistors, and more particularly to power efficient field effect transistors.

In general, power transistors are not always operated in a power efficient manner, this is especially true for field effect transistors (FETs) such as MOSFETSs (metallic oxide semiconductor field effect transistors) or MESFETs (metal semiconductor field effect transistors). Integrated power FETs are generally made as a large single device structure or many small FETs coupled in parallel to form a single power FET. Typically, the choice of a power FET is determined by the maximum power output and the frequency response required. The power FET is chosen to meet the maximum power requirement even though it is operated at these maximum levels infrequently. Since the majority of the power FET operation will reside at levels significantly lower than the maximum power level of the circuit it will be biased inefficiently and waste power. This can be extremely critical for battery powered applications where battery life is related to the quiescent power dissipated through power FETs. An example of a battery application using power FETs is a cellular telephone which has an amplifier for transmitting to a receiving station. Increasing efficiency of power FETs in the transmitting amplifier can significantly extend battery life thereby increasing transmission time.

It would be of great benefit if a power field effect transistor could be developed which meets the maximum power requirement of an application yet operates power efficiently.

### Summary of the Invention

Briefly stated, this invention comprises a power FET (field effect transistor) that includes a gate terminal, a drain terminal, a source terminal, and at least one control terminal for varying the width of the power FET.

The power FET comprises a FET and at least one switch FET. The FET includes a gate, a drain, and a source coupled respectively to the gate terminal, drain terminal, and source terminal of the power FET. Each switch FET includes a gate, a drain, and a source coupled respectively to the gate terminal, drain terminal, and source terminal of the power FET. Each switch FET has a control gate for enabling the device, the control gate is coupled to a control terminal of the power FET. Each enabled switch FET couples in parallel to the FET for increasing the size of the power FET.

A method for operating a power FET efficiently. The power FET receives a DC bias current. A portion of the power FET is operated under quiescent conditions. Purther remaining portions of the power FET are enabled to increase power output.

A method for forming a variable width FET. The variable width power FET is formed having a switchable portion for increasing or decreasing the width of the variable width FET.

### Brief Description of the Drawings

FIG. 1 is a schematic diagram of a high efficiency monolithic power FET (field effect transistor) in accordance with the present invention;
FIG. 2 is a schematic diagram of an amplifier utilizing a high efficiency monolithic power FET to reduce power; and
FIG. 3 is a layout of a high efficiency monolithic power FET in accordance with the present invention.

### Detailed Description of the Drawings

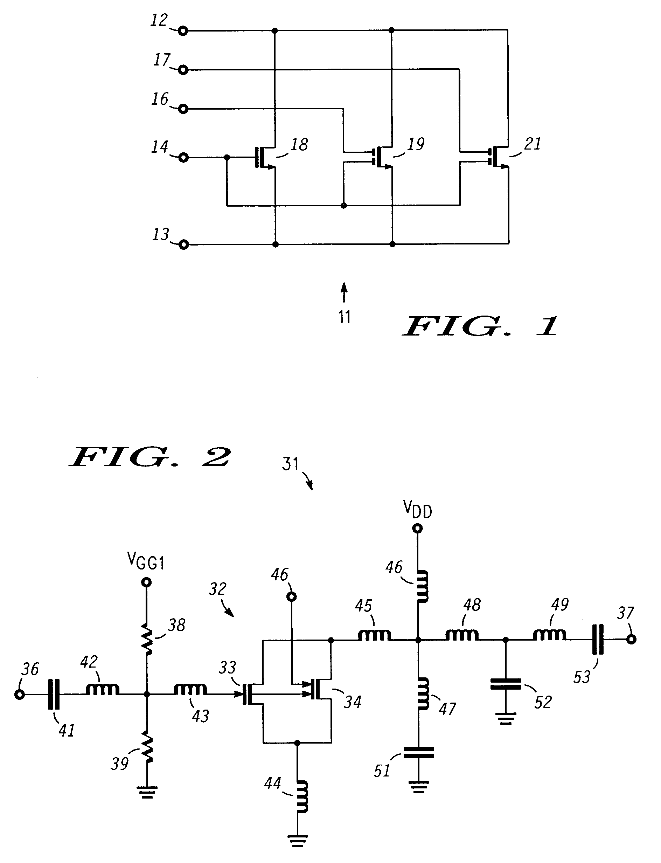

FIG. 1 is a schematic diagram of a high efficiency monolithic power FET (field effect transistor) 11. Power FETs, in general, may be a single large device or comprise a large number of smaller transistors in parallel to form a single large device. One common application for a power FET is in an output stage of an amplifier. The devices used in the output stage are typically chosen to meet the maximum power rating of the amplifier. This is not power efficient due to the fact that bias current in the output stage of the amplifier is proportional to the FET size. A smaller power FET in the output stage can be biased with a lower current (thereby reducing power consumption) but is a reliability problem if the amplifier is operated at full power. Monolithic power FET 11 solves this problem by having a reduced size under quiescent operating conditions, thus allowing a smaller bias current to be used and being adjustable to increase device size proportional to the operating power requirements.

Monolithic power FET 11 is designed for analog circuits which require a DC bias current while delivering power over a wide range. The structure of monolithic power FET 11 is suitable for most types of field effect transistors, for example, MESFETs (metal semiconductor FETs) or MOSFETs (metallic oxide semiconductor FETs). Monolithic power FET 11 is fabricated using standard integrated circuit process techniques and includes a drain terminal 12, a source terminal 13, a gate terminal 14, a control terminal 16, and a control terminal 17. Monolithic power transistor 11 as shown in FIG. 1 comprises a FET 18, a switch FET 19, and a switch FET 21. FET 18 is a non-switchable portion of monolithic power FET 11. Switch FETS 19 and 21 can be enabled and disabled for varying the width of monolithic power FET 11. FET 18 has a gate, a drain, and a source coupled respectively to gate terminal 14, drain terminal 12, and source terminal 13 of monolithic power FET 11. Switch FETs 19 and 21 each include a gate, a drain, and a source coupled respectively to gate terminal 14, drain terminal 12, and source terminal 13. Switch FET 19 has a control gate coupled to control terminal 16 and switch FET 21 has a control gate coupled to control terminal 17 of monolithic power FET 11. Control signals are applied to control terminals 16 and 17 for enabling and disabling switch FETs 19 and 21 thereby coupling the two switch FETs in parallel to FET 18.

Operation of monolithic power FET 11 is similar to a standard FET with the exception of control terminals 16 and 17. FET 18 is enabled when monolithic power FET 11 is enabled. Switch FETs 19 and 21 are enabled by voltage signals applied to control terminals 16 and 17. It is well known that a FET is characterized by its width to gate length ratio (W/L). Control terminals 16 and 17 allow monolithic power FET 11 to behave as a variable width FET. Disabling switch FETs 19 and 21 allows only a portion of monolithic power FET 11 to be operated. This usually occurs under quiescent conditions and over a limited low power range in which FET 18 is adequate. As power requirements increase for monolithic power FET 11 the remaining portion of the device (switch FETs 19 and 21) are enabled simultaneously or incrementally. Incremental enabling of the switch FETs provides a finer control of the width of monolithic power FET 11 for maintaining optimum size over all operating conditions. DC power consumption can be reduced by keeping the area of FET 18 to a minimum. Although two switch FETs are illustrated in FIG. 1 it should be understood that as few as one or as many switch FETs as desired may be coupled in parallel as has been described above. In the preferred embodiment, the geometry of FET 18 is chosen for the quiescent conditions of the application in which the FET is used. Individual control terminals allow switch FETs to be enabled as power requirements dictate, at maximum power some, if not all if the switch FETs would be enabled. As illustrated, FET 18 and FETs 19 and 21 are of the same conductive type.

FIG. 2 is an example that illustrates a monolithic power FET 32 incorporated in a high frequency amplifier stage 31. High frequency amplifier stage 31 has an input 36 to which a signal is applied and provides and amplified signal at output 37. Monolithic power FET 32 comprises a FET 33 and a switch FET 34 in the manner described above. In the preferred embodiment, monolithic power FET 32 is a MESFET. MESFETs are well known for their high frequency performance. MESFETs are commonly used in the output stages of battery powered amplifiers which transmit at frequencies greater than several hundred megahertz, for example, a cellular telephone.

Resistors 38 and 39 form a resistor divider coupled to a power source VGG1 for providing a DC bias voltage to monolithic power FET 32. A capacitor 41 and inductors 42 and 43 form an impedance matching stage for matching high frequency amplifier stage 31, for example, to a preceding stage (not illustrated). It is well known that impedance matching is essential for both maximum power transfer and maximum efficiency.

The source of monolithic power FET 32 is grounded through an inductor 44. A voltage applied to a control input 46 of monolithic power FET 32 enables and disables switch FET 34. The drain of monolithic power FET 32 couples to an output impedance matching circuit. The output impedance matching circuit comprises inductors 45-49 and capacitors 51-53. Output 37 is typically coupled to a filter or an antenna.

Operation of high frequency amplifier stage 31 has two distinct modes. In the first mode, as a signal applied to input 36 is below a predetermined level switch FET 34 is disabled by a signal applied to control input 46. In this mode DC bias voltage applied to monolithic power FET 32 via resistors 38 and 39 is sufficient to enable FET 33 and 34. A signal provided to control input 46 disables FET 34 thereby reducing bias current and power consumption of high frequency amplifier stage 31. FET 33 is sufficient in size for amplifying input signals below the predetermined level.

In the second mode, the signal applied to input 36 exceeds the predetermined level. In this mode a signal applied to control input 46 enables switch FET 34 to be coupled in parallel to FET 33. The increased size of monolithic power FET 32 is sufficient to handle the higher power output required of the input signal to high frequency amplifier stage 31. Thus, until the input signal level applied to FET 31 exceeds a certain level only a portion of FET 32 is enabled (FET33). Once the input signal exceeds this level the remaining portion of FET 32 is enabled (FET 34).

Input capacitance for monolithic power FET 32 is similar to a standard power FET. The dominant capacitance of the input capacitance is the gate capacitance of the device. Input capacitance is a critical component to the input impedance matching stage and cannot vary over the operating range of high frequency amplifier stage 31 without significantly affecting power transfer characteristics. In the preferred embodiment, the input capacitance of monolithic power FET 32 remains relatively constant when switch FET 34 is enabled or disabled thereby maximizing input power transfer. The gates of both FET 33 and switch FET 34 are coupled to the input impedance matching stage. Similarly, the output impedance of monolithic power FET 32 affects the output impedance matching stage. Enabling switch FET 34 does change the output impedance of monolithic power FET 32 slightly (typically 5-7 percent) but the change is not enough to severely degrade the impedance match. Monolithic power FET 32 reduces DC power consumption, does not significantly affect impedance matching stages, and meets maximum power requirements of high frequency amplifier stage 31.

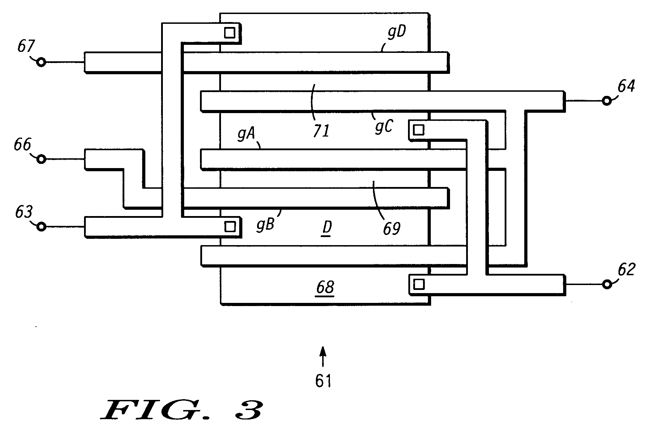

FIG. 3 is an illustration of a physical layout of a monolithic power FET 61 depicted in the schematic of FIG. 1. Monolithic power FET 61 has a gate terminal 64, a drain terminal 63, a source terminal 62, a control terminal 66, and a control terminal 67. Monolithic power FET 61 comprises a FET 68, a switch FET 69, and a switch FET 71.

FET 68 is a standard FET structure with a gate coupled to gate terminal 64, a drain coupled to drain terminal 63, and a source coupled to source terminal 62. The source of FET 68 is common with the source of FET 69. Switch FETs 71 and 69 are made switchable by each having two gates in series. A series gate structure will not flow current from drain to source unless an appropriate voltage is applied to each gate of the switch FET. In the preferred embodiment, a control gate (one of the series gates) is biased to fully enable the switch FET. The remaining gate of the two series gates is operated as a standard gate such as the gate of FET 68.

Switch FET 69 has a gate (gA) coupled to gate terminal 64, a drain coupled to drain terminal 63, a source (sA) coupled to source terminal 62, and a control gate (gB) coupled to control terminal 66. The drain (D) of switch FET 69 is common with a drain of switch FET 71. Switch FET 71 has a gate (gC) coupled to gate terminal 64, the drain (D) coupled to drain terminal 63, a source (shared with FET 69) coupled to source terminal 62, and a control gate (gD) coupled to control terminal 67. The layout shown is only one variation of many which could be used, the layout of monolithic power FET 61 should minimize parasitic resistances and capacitances.

As mentioned previously, the number of switch FETs incorporated in a monolithic power FET is dependent on the application. Additional switch FETs provide increased refinement for adjusting the size (or width) of the monolithic power FET but at the expense of additional control signals.

By now it should be appreciated that a monolithic power FET has been provided that is easily fabricated using standard semiconductor processing techniques. The monolithic power FET has an adjustable width while maintaining input and output characteristics similar to a standard non-adjustable FET.

## Claims

1. A monolithic power FET (11) (field effect transistor) comprising:
a FET (18) including a gate, a drain, and a source; and
at least one switch FET (19,21), said at least one switch FET including a first gate coupled to said gate of said FET, a second gate, a drain coupled to said drain of said FET, and a source coupled to said source of said FET.

2. A monolithic power FET (11) as recited in claim 1 wherein said first and second gates of said at least one switch FET (19,21) are formed in series between said drain and source thereof.

3. A monolithic power FET (11) as recited in claim 2 wherein said second gate of said at least one switch FET (19,21) being coupled to a terminal to which a voltage signal is applied thereto for enabling said switch FET (19,21).

4. A monolithic power FET (11) as recited in claim 3 wherein said second gate of said at least one switch FET (19,21) is located closer to said drain than said source thereof.

5. A method for operating a power FET (11) efficiently, the power FET (11) receiving a DC bias current, the method comprising:
enabling only a portion of the power FET (11) under quiescent operating conditions and below a predetermined input signal level; and
enabling a remaining portion of the power FET (11) in conjunction with said enabled portion above said predetermined input signal level.

6. A method as recited in claim 5 wherein said enabling a remaining portion of the power FET (11) step includes
incrementally enabling discrete areas of said remaining portion of the power FET (11) as power requirements increase, each incremental enabling of said discrete areas increasing the width of the power FET (11).

7. A method for forming a variable width FET (11) (field effect transistor) comprising:
forming a non-switchable portion of the variable width FET (11); and
forming a switchable portion of the variable width FET (11) to vary the width of the variable width FET (11).

8. The method as recited in claim 7 wherein said forming a non-switchable portion step includes
forming a FET (18) corresponding to said non-switchable portion having a gate, a drain, and a source coupled respectively to a gate, a drain, and a source of the variable width FET (11).

9. The method as recited in claim 8 wherein said forming a switchable portion step includes
forming at least one switch FET (19,21) having a first gate, a drain, and a source coupled respectively to a gate, a drain, and a source of the variable width FET (11), said at least one switch FET (19,21) further including a second gate for enabling said at least one switch FET (19,21) for increasing the width of the variable width FET (11).

10. The method as recited in claim 9 wherein said step of forming at least one switch FET (19,21) includes
forming said first and second gates in series between said drain and said source of said at least one switch FET (19,21).
